# DEMANDE DE BREVET EUROPEEN

(11) **EP 2 053 301 A1**
(43) Date de publication de la demande: **29.04.2009**
(21) Numéro de dépôt: 08167355.0
(22) Date de dépôt: 23.10.2008
(51) Int. Cl.: F21K 7/00, F21Y 101/02

(54) **Lampe à diode électroluminescente**

(30) Priorité: 23.10.2007 FR 0758486
(71) Demandeur: Mafelec, 38490 Chimilin (FR)
(72) Inventeur: Denisa, Patrick, 38110 La Batie Montgascon (FR); Legrand, Bertrand, 38000 Grenoble (FR)
(74) Mandataire: Thibault, Jean-Marc

(57) **Abrégé**

L'invention concerne une lampe à diode électroluminescente comportant un culot métallique **(2)** définissant avec un plot central **(5),** des bornes de connexion à une source d'alimentation électrique, le culot métallique **(2)** étant surmonté par une coiffe de protection **(8)** délimitant en son centre, un logement de réception pour une diode électroluminescente **(14)** supportée par une plaquette de support **(15)** logée à l'intérieur de la lampe et servant à la fixation de composants électroniques formant un circuit électronique comportant un étage **(21)** résistif et de protection contre les perturbations électromagnétiques. Un étage de filtration des variations de tension de la source d'alimentation électrique est disposé sur la plaquette de support **(15)** entre le pont redresseur et l'étage résistif et de protection, et les composants électroniques de l'étage résistif et de protection **(21)** sont montés sur la plaquette de support **(15),** de manière à être situés à l'intérieur du culot métallique **(2)** qui est rempli par une résine thermoconductrice **(40).**

## Description

La présente invention concerne le domaine technique de l'éclairage au sens général, et elle vise plus précisément une lampe à culot métallique, à vis ou à baïonnette.

La présente invention trouve une application particulièrement avantageuse pour une lampe à culot métallique à baïonnette de préférence de type BA9S.

Dans l'état de la technique, il est connu d'utiliser dans de nombreuses applications, des lampes à culot du type à incandescence. Pour remédier notamment à un problème de rendement, il a été proposé de remplacer le filament d'une telle lampe par une diode électroluminescente, en conservant le culot métallique, afin de pouvoir remplacer en lieu et place sans modification, une lampe à incandescence par une lampe à diode électroluminescente.

L'utilisation d'une diode électroluminescente nécessite d'y associer un circuit électrique de commande et de protection. Ainsi, le circuit électrique doit mettre en oeuvre un étage résistif de limitation de courant et de protection contre les perturbations électromagnétiques. De plus, compte tenu de l'incertitude sur la polarité de la source d'alimentation, le circuit électrique comporte un étage redresseur. Enfin, il devient nécessaire de monter en série avec la diode électroluminescente, une diode à tension de seuil permettant de fixer une valeur de tension d'alimentation au-dessus de laquelle la diode est allumée. A cet égard, il s'avère nécessaire de remédier au problème des perturbations de la tension d'alimentation, qui conduisent à un problème de scintillement de la diode électroluminescente, ne permettant pas d'obtenir un fonctionnement pour des valeurs précises de la tension d'alimentation.

Dans l'état de la technique, il est connu par le document EP 0 876 085 une lampe à diode électroluminescente comportant un culot métallique définissant avec un plot central, des bornes de connexion à une source d'alimentation électrique. Le culot métallique est surmonté par une coiffe de protection délimitant en son centre, un logement de réception pour une diode électroluminescente supportée par une plaquette de support logée à l'intérieur de la lampe et servant à la fixation de composants électroniques formant un circuit électronique comportant un étage résistif et de protection contre les perturbations électromagnétiques, monté entre les bornes de connexion et un pont redresseur alimentant la diode électroluminescente.

Par ailleurs, l'adaptation d'une diode électroluminescente sur une lampe à culot métallique, pose un problème de montage des composants du circuit électrique de commande et de protection. En effet, une telle lampe présente une taille limitée, de sorte qu'il est difficile de loger à l'intérieur de la lampe, les différents composants électroniques devant être associés à une telle diode électroluminescente. De façon complémentaire, il apparaît un problème d'échauffement, et par suite un problème de détérioration des composants électroniques sensibles à la chaleur. En effet, il s'avère que les composants résistifs sont placés à proximité des composants électroniques sensibles à la température, compte tenu de la faible place disponible à l'intérieur de la lampe.

La présente invention vise donc à remédier aux inconvénients de l'état de la technique, en proposant une lampe à diode électroluminescente à culot métallique, conçue pour présenter une plage déterminée de fonctionnement, quelles que soient les perturbations de la tension d'alimentation, tout en permettant de présenter une durée de vie relativement élevée en préservant les composants électroniques d'un échauffement trop important.

Pour atteindre un tel objectif, la lampe à diode électroluminescente comporte un culot métallique définissant avec un plot central, des bornes de connexion à une source d'alimentation électrique, le culot métallique étant surmonté par une coiffe de protection délimitant en son centre, un logement de réception pour une diode électroluminescente supportée par une plaquette de support logée à l'intérieur de la lampe et servant à la fixation de composants électroniques formant un circuit électronique comportant un étage résistif et de protection contre les perturbations électromagnétiques, monté entre les bornes de connexion et un pont redresseur. Selon l'invention, une diode à tension de seuil est montée en série avec la diode luminescente et un étage de filtration des perturbations en fréquence de la source d'alimentation électrique est disposé sur la plaquette de support entre le pont redresseur et l'étage résistif et de protection, et les composants électroniques de l'étage résistif et de protection sont montés sur la plaquette de support, de manière à être situés à l'intérieur du culot métallique qui est rempli par une résine thermoconductrice afin de transférer et d'évacuer par le culot métallique, les calories provenant de l'étage résistif et de protection.

Selon une variante préférée de réalisation, l'étage de filtration comporte un condensateur monté en parallèle du pont redresseur.

Avantageusement, l'étage de filtration comporte une fréquence de coupure adaptée pour éliminer les perturbations en fréquence de la source d'alimentation électrique, conduisant à un scintillement de la diode électroluminescente.

Par ailleurs, l'étage de filtration comporte une fréquence de coupure adaptée pour éliminer les perturbations en fréquence de la source d'alimentation électrique présentant une valeur de tension supérieure à la tension de seuil de la diode à tension de seuil.

Selon une variante préférée de réalisation, la résine thermoconductrice remplit également l'intérieur de la coiffe de protection.

Selon un exemple préféré de réalisation, l'étage résistif et de protection comporte deux résistances montées en série en étant reliées à une borne de connexion et à l'autre borne de connexion via une diode transil, les deux résistances étant reliées à une borne du condensateur à l'aide d'une résistance.

Avantageusement, la plaquette de support est un circuit imprimé.

Par exemple, la coiffe de protection et le culot métallique sont assemblés ensemble à l'aide d'une bague intermédiaire.

De préférence, l'étage redresseur est un pont à 4 diodes.

Selon une application préférée, le culot métallique est à baïonnette de type de préférence BA9S.
La **Figure 1** est une vue de dessus en perspective d'une lampe conforme à l'invention.
La **Figure 2** est une vue de dessous en perspective d'une lampe conforme à l'invention.
La **Figure 3** est une vue éclatée en perspective d'une lampe conforme à l'invention.
La **Figure 4** est un schéma électrique de la lampe conforme à l'invention.
La **Figure 5** est une vue en coupe longitudinale d'une lampe conforme à l'invention, prise sensiblement selon les lignes **V** de la **Fig. 2****.**

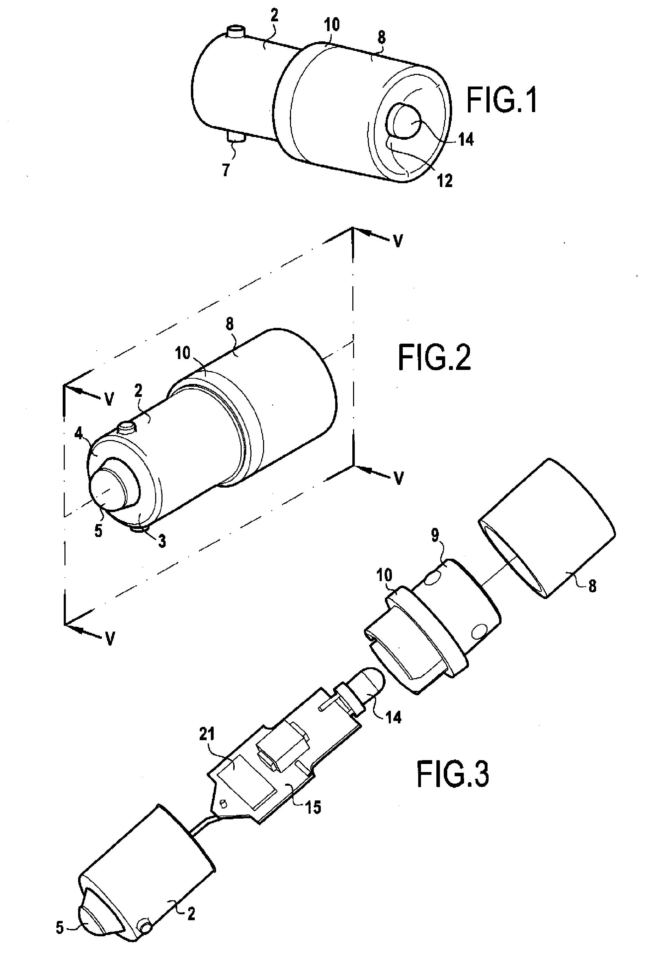

Tel que cela ressort plus précisément des **Fig. 1** à **5****,** l'objet de l'invention concerne une lampe **1** à culot métallique **2** au sens général du type à vis ou à baïonnette. Selon une application avantageuse décrite ci-après, l'objet de l'invention concerne une lampe avec un culot métallique **2** à baïonnette du type de préférence BA9S. Cette lampe **1** comporte un culot métallique **2** présentant de manière classique une forme tubulaire de section droite transversale circulaire. Le culot métallique **2** est muni d'un fond **3** présentant un trou pour le montage d'une bague isolante **4** de section tronconique équipée en son centre, d'un plot central **5** métallique. De manière classique, le culot métallique **2** et le plot métallique **5** définissent les deux bornes de connexion de la lampe à une source d'alimentation électrique par l'intermédiaire d'un connecteur non représenté mais connu en soi.

Dans l'exemple préféré de réalisation, le culot métallique **2** est pourvu à sa surface externe, de deux ergots saillants **7** diamétralement opposés, de manière à former un culot à baïonnette adapté pour être monté dans un connecteur associé. Le culot métallique **2** est ouvert à l'opposé de son fond **3,** pour permettre de recevoir une coiffe de protection **8** réalisée en tout matériau approprié. De préférence, la coiffe **8** est montée sur le culot métallique **2,** à l'aide d'une bague d'assemblage intermédiaire **9** présentant une collerette saillante **10** sur laquelle prend appui d'un côté, le culot métallique **2** et, de l'autre côté, la coiffe de protection **8.**

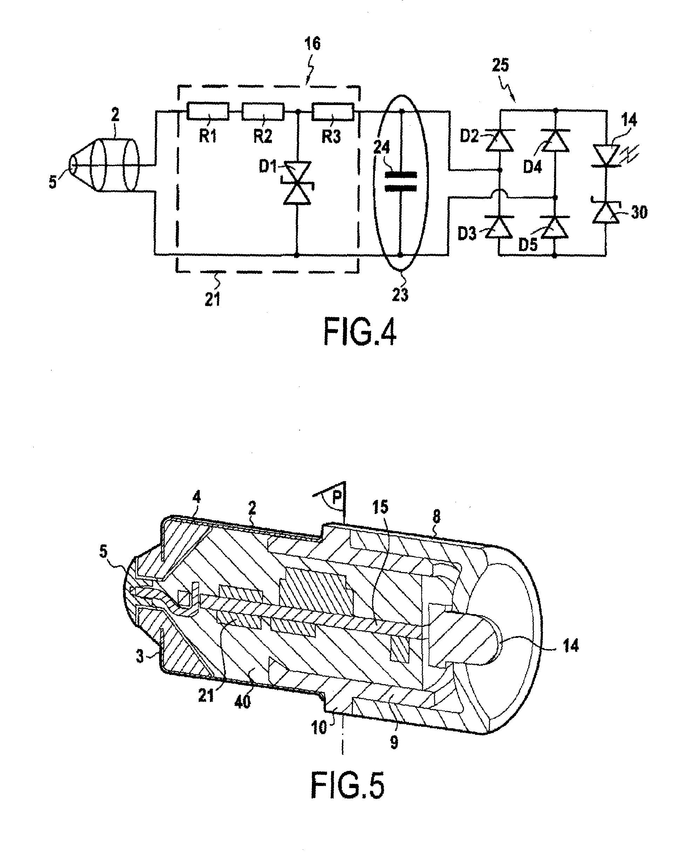

La coiffe de protection **8** délimite en son centre, un logement **12** de réception pour une diode électroluminescente **14** s'étendant légèrement en saillie par rapport à la coiffe de protection **8.** Tel que cela ressort plus précisément des **Fig. 3** et **5****,** la diode électroluminescente **14** est supportée par une plaquette de support **15,** telle qu'un circuit imprimé.

Le circuit imprimé **15** permet la fixation de divers composants électroniques formant un circuit électronique **16** tel qu'illustré à la **Fig. 4****.** Le circuit électronique **16** comporte un étage **21** résistif et de protection contre les perturbations électromagnétiques, monté aux bornes du culot métallique **2** et du plot central **5.** Selon un exemple préféré de réalisation, l'étage résistif **21** comporte trois résistances en série **R₁, R₂** et **R₃,** avec la résistance **R₁** reliée dans l'exemple illustré au plot central **5.** Le point commun entre les résistances **R₂** et **R₃** sert de liaison pour une borne d'une diode transil **D₁** de protection contre les perturbations électromagnétiques, dont l'autre borne est reliée au culot métallique **2.**

Selon une caractéristique de l'invention, le circuit électronique **16** comporte un étage **23** de filtration des variations de la tension de la source d'alimentation électrique conduisant à un scintillement de la diode électroluminescente.

Selon une caractéristique préférée de réalisation, cet étage de filtration **23** comporte un condensateur **24** dont l'une des bornes est reliée à la résistance **R₃,** tandis que l'autre borne est reliée au point commun entre le culot métallique **2** et la diode transil **D₁.**

Selon une caractéristique avantageuse de réalisation, le condensateur **23** est disposé entre l'étage résistif et de protection **21** et un pont redresseur **25.**

De préférence, le pont redresseur **25** comporte 4 diodes **D₂** à **D₅.** Les diodes **D₂** et **D₃** sont montées en série dans une branche parallèle à une branche comportant les diodes **D₄** et **D₅** montées également en série.

L'une des bornes du condensateur **24** est reliée au point commun entre les diodes **D₂** et **D₃,** tandis que l'autre borne du condensateur **24** est reliée au point commun entre les diodes **D₄** et **D₅.** Le pont redresseur **25** alimente la diode électroluminescente **14** montée en série avec une diode à tension de seuil **30** telle une diode zener permettant de déterminer la tension de seuil ou d'allumage de la diode électroluminescente **14.**

En effet, il doit être considéré que la diode zener **30** présente une tension de seuil **V** au-delà de laquelle la diode électroluminescente **14** éclaire. Toutefois, il apparaît que la source d'alimentation électrique peut présenter des perturbations en fréquence supérieures à cette tension de seuil **V** ayant pour conséquence d'entrainer un scintillement de la diode électroluminescente **14.** Il est à noter que l'étage de filtration **23** comporte une fréquence de coupure adaptée pour éliminer les perturbations en fréquence de la source d'alimentation électrique conduisant à un scintillement de la diode électroluminescente **14.** L'étage de filtration **23** comporte une fréquence de coupure adaptée pour éliminer les perturbations en fréquence de la source d'alimentation électrique présentant une valeur de tension supérieure à la valeur **V** de la tension de la diode zener **30** mais présentant une fréquence élevée. Typiquement, l'étage de filtration **23** permet d'éliminer les sauts brusques ou ponctuels de tension supérieurs à la valeur **V** de la tension de seuil. Il est à noter que dans le cas où la source d'alimentation électrique délivre une tension alternative, l'étage de filtration **23** est adapté pour ne pas filtrer la tension alternative d'alimentation. Ainsi, si la tension d'alimentation présente une fréquence maximale de l'ordre de 400 Hz, la fréquence de coupure de l'étage de filtration **23** est supérieure à cette valeur de fréquence maximale.

Selon une autre caractéristique de l'objet de l'invention, les composants électroniques de l'étage résistif et de protection **21** sont montés sur le circuit imprimé **15,** de manière à être situés à l'intérieur du culot métallique **2.** En d'autres termes, et tel que cela ressort plus précisément de la **Fig. 5****,** les composants de l'étage résistif et de protection **21** sont montés de manière à s'étendre à un niveau inférieur de celui délimité par le plan **P** passant par le bord extrême libre du culot métallique **2,** en appui sur l'épaulement **10** de la bague **9.** De préférence, les composants de l'étage redresseur **25,** la diode zener **30** et la diode électroluminescente **14** sont montés sur le circuit imprimé **15** de manière à être situés en dehors du culot métallique **2.** De préférence, la diode électroluminescente **14** est montée sur le circuit imprimé **15** sur le bord opposé du bord voisin du plot central **5.** Il est à noter que le condensateur **24** est monté sur le circuit imprimé **15** de manière indifférente par rapport au plan **P.**

Avantageusement, le culot métallique **2** est rempli par une résine thermoconductrice **40** adaptée pour transférer et évacuer par le culot métallique **2** les calories provenant essentiellement de l'étage résistif et de protection **21** et notamment des résistances **R₁** à **R₃.**

Selon une caractéristique préférée de l'invention, la résine conductrice **40** remplit complètement l'intérieur de la lampe **1.** Ainsi, tel que cela ressort plus précisément de la **Fig. 5****,** la résine conductrice **40** remplit à la fois le culot métallique **2** et l'intérieur de la coiffe de protection **8.**

Il ressort de la description qui précède que la lampe **1** éclaire avec une diode électroluminescente tout en présentant une plage de fonctionnement déterminée insensible aux fluctuations en fréquence de la tension d'alimentation électrique en raison de l'étage de filtration **23.** Par ailleurs, il doit être considéré que le circuit électronique **16** est optimisé pour avoir un nombre réduit de composants qui sont disposés les uns par rapport aux autres pour tenir compte de leur fonctionnement à l'intérieur de la lampe, afin d'éviter que les composants sensibles à la chaleur se trouvent placés à proximité des résistances. De façon avantageuse, les résistances **R₁** à **R₃** sont placées à l'intérieur du culot métallique **2** qui sert de radiateur thermique pour la chaleur transmise via la résine thermoconductrice **40.** Ainsi, les résistances **R₁** à **R₃** sont disposées le plus près possible du fond du culot métallique **2,** à savoir à l'opposé de la coiffe **8.**

L'invention n'est pas limitée aux exemples décrits et représentés car diverses modifications peuvent y être apportées sans sortir de son cadre.

## Revendications

1. **-** Lampe à diode électroluminescente comportant un culot métallique **(2)** définissant avec un plot central **(5),** des bornes de connexion à une source d'alimentation électrique, le culot métallique **(2)** étant surmonté par une coiffe de protection **(8)** délimitant en son centre, un logement de réception **(12)** pour une diode électroluminescente **(14)** supportée par une plaquette de support **(15)** logée à l'intérieur de la lampe et servant à la fixation de composants électroniques formant un circuit électronique **(16)** comportant un étage **(21)** résistif et de protection contre les perturbations électromagnétiques, monté entre les bornes de connexion **(2, 5)** et un pont redresseur **(25)** alimentant la diode électroluminescente **(14), caractérisée en ce qu'**une diode à tension de seuil **(30)** est montée en série avec la diode électroluminescente **(14)** et **en ce qu'**un étage **(23)** de filtration des perturbations en fréquence de la source d'alimentation électrique est disposé sur la plaquette de support **(15)** entre le pont redresseur **(25)** et l'étage résistif et de protection **(21),** et **en ce que** les composants électroniques de l'étage résistif et de protection **(21)** sont montés sur la plaquette de support **(15),** de manière à être situés à l'intérieur du culot métallique **(2)** qui est rempli par une résine thermoconduçtrice **(40)** afin de transférer et d'évacuer par le culot métallique **(2),** les calories provenant de l'étage résistif et de protection **(21).**

2. **-** Lampe à diode électroluminescente selon la revendication 1, **caractérisée en ce que** l'étage de filtration **(23)** comporte un condensateur **(24)** monté en parallèle du pont redresseur **(25).**

3. **-** Lampe à diode électroluminescente selon la revendication 1 ou 2, **caractérisée en ce que** l'étage de filtration **(23)** comporte une fréquence de coupure adaptée pour éliminer les perturbations en fréquence de la source d'alimentation électrique, conduisant à un scintillement de la diode électroluminescente **(14).**

4. **-** Lampe à diode électroluminescente selon la revendication 3, **caractérisée en ce que** l'étage de filtration **(23)** comporte une fréquence de coupure adaptée pour éliminer les perturbations en fréquence de la source d'alimentation électrique présentant une valeur de tension supérieure à la tension de seuil de la diode à tension de seuil **(30).**

5. **-** Lampe à diode électroluminescente selon la revendication 1, **caractérisée en ce que** la résine thermoconductrice **(40)** remplit également l'intérieur de la coiffe de protection **(8).**

6. **-** Lampe à diode électroluminescente selon les revendications 1 et 2, **caractérisée en ce que** l'étage résistif et de protection **(21)** comporte deux résistances **(R₁, R₂)** montées en série en étant reliées à une borne de connexion et à l'autre borne de connexion via une diode transil **(D₁),** les deux résistances **(R₁, R₂)** étant reliées à une borne du condensateur **(24)** à l'aide d'une résistance **(R₃).**

7. **-** Lampe à diode électroluminescente selon la revendication 1 ou 3, **caractérisée en ce que** la plaquette de support **(15)** est un circuit imprimé.

8. **-** Lampe à diode électroluminescente selon la revendication 1, **caractérisée en ce que** la coiffe de protection **(8)** et le culot métallique **(2)** sont assemblés ensemble à l'aide d'une bague intermédiaire.

9. **-** Lampe à diode électroluminescente selon la revendication 1, **caractérisée en ce que** l'étage redresseur **(25)** est un pont à 4 diodes **(D₂** à **D₅).**

10. **-** Lampe à diode électroluminescente selon la revendication 1, **caractérisée en ce que** le culot métallique **(2)** est à baïonnette de type de préférence BA9S.
